Europäisches Patentamt

European Patent Office

Office européen des brevets

(19)

(11) Numéro de publication: **0 109 106**
**B1**

(12) **FASCICULE DE BREVET EUROPEEN**

(45) Date de publication du fascicule du brevet: **07.01.87**

(51) Int. Cl.⁴: **H 03 K 19/092**

(21) Numéro de dépôt: **83201475.7**

(22) Date de dépôt: **14.10.83**

(54) **Circuit convertisseur de niveaux de signaux entre une logique de type saturée et une logique de type non saturée.**

(30) Priorité: **18.10.82 FR 8217397**

(43) Date de publication de la demande:
**23.05.84 Bulletin 84/21**

(45) Mention de la délivrance du brevet:
**07.01.87 Bulletin 87/02**

(84) Etats contractants désignés:
**DE FR GB NL**

(56) Documents cités:
**EP-A-0 052 565**
**US-A-3 660 676**

**IBM TECHNICAL DISCLOSURE BULLETIN, vol.
12, no. 2, juillet 1969, page 296, New York, US
D. M. TAYLOR et al.: "Logic signal level shift
circuit"**

(73) Titulaire: **RTC-COMPELEC**
**130, Avenue Ledru-Rollin**
**F-75011 Paris (FR)**
(84) **FR**
(73) Titulaire: **N.V. Philips' Gloeilampenfabrieken**
**Groenewoudseweg 1**
**NL-5621 BA Eindhoven (NL)**
(84) **DE GB NL**

(72) Inventeur: **Gloaguen, Gilbert**
**Société Civile S.P.I.D. 209 rue de l'Université**
**F-75007 Paris (FR)**
Inventeur: **Moussie, Michel**
**Société Civile S.P.I.D. 209 rue de l'Université**
**F-75007 Paris (FR)**

(74) Mandataire: **Pinchon, Pierre et al**
**Société Civile S.P.I.D. 209 rue de l'Université**
**F-75007 Paris (FR)**

Courier Press, Leamington Spa, England.

EP 0 109 106 B1

# 0 109 106

**Description**

La présente invention concerne un circuit convertisseur de niveaux de signaux entre, d'une part une première logique de type saturée à deux niveaux de signaux de sortie, alimentée par une première alimentation continue dont une des bornes constitue la référence commune de potentiel et, d'autre part une seconde logique de type non saturée à deux autres niveaux de signaux, alimentée par une seconde alimentation continue dont une des bornes est connectée à la référence commune de potentiel, et l'autre borne est à une tension de polarité opposée à celle de l'autre de l'autre borne de la première alimentation continue, une borne de transit recevant les signaux de sortie de la première logique pour être convertis en signaux aux niveaux convenables pour l'entrée de la seconde logique, circuit convertisseur comportant un transistor émetteur suiveur dont la base est reliée à un premier point du circuit à potentiel défini par rapport à celui de la référence commune, via une première jonction semiconductrice en sens direct, et reçoit d'autre part les signaux de sortie de la première logique à partir de la borne de transit, dont l'émetteur, d'une part est soumis à l'effet d'une source de courant constant, connectée par ailleurs à ladite autre borne de la seconde alimentation, et d'autre part est connecté à une première connexion d'un élément de charge pour la source de courant constant, tandis que la deuxième connexion de cet élément peut être connectée au premier point du circuit à potentiel défini.

Dans les installations de traitement des signaux numériques, et notamment dans les ordinateurs modernes, il est nécessaire de transformer des signaux ayant les niveaux correspondant à ceux de la logique TTL (ou d'une logique équivalente) en signaux adaptés à une logique de type ECL/CML, et vice-versa.

En effet, l'utilisation de la logique de type TTL est très répandue dans tous les cas où une faible consommation est requise et la vitesse de commutation n'est pas un impératif absolu, comme dans le cas des organes périphériques par exemple. Par contre, une logique du type ECL/CML, à commutation de courant, se révèle plus rapide par l'absence de saturation et la réduction de l'excursion logique. Elle est donc avantageusement utilisée au sein des organes centraux devant traiter des informations numériques à très grande vitesse.

Il est donc souhaitable de pouvoir convertir les signaux entre ces différents types de logiques tout en assurant les meilleures conditions de transfert possibles: il faut, en effet, obtenir des seuils de basculement prédéterminés en présence d'un certain niveau de bruit, selon une large plage de température, en présence de fluctuations des alimentations. Par ailleurs, en plus des critères de type électrique, viennent s'ajouter des considérations technologiques comme la facilité d'intégration de ces circuits convertisseurs, le nombre d'éléments requis et donc leur complexité et, également, leur sensibilité aux fluctuations inévitables liées aux procédés de fabrication.

Un circuit convertisseur tel que défini en préambule est connu du document EP—A—0 052 565.

Selon le circuit connu, le transistor émetteur suiveur travaille à des tensions qui sont dans tous les cas comprises entre la tension de référence commune (0 volt) et la tension $V_{cc}$. Il est ainsi proposé de créer une tension particulière de référence (désignée par VCM dans le document en question), création qui requiert à cet effet un nombre non négligeable d'éléments semi-conducteurs.

Le signal converti sur l'émetteur du transistor émetteur suiveur subit ensuite une translation de niveau au moyen d'une chaîne de quatre diodes polarisées en direct. Cette translation de niveau introduit une variabilité en température qui s'écarte de celle requise par la seconde logique de sorte qu'une autre tension de référence particulière est constituée pour servir de comparaison avec le signal translaté, et pour corriger par différence la variabilité en température de ce signal. L'invention se propose de remédier aux inconvénients du circuit connu et a notamment pour but de fournir un circuit convertisseur de structure plus simple dont les éléments, peu nombreux, peuvent facilement être intégrés avec une fonction complexe de la deuxième logique.

En effet, selon l'invention, un circuit convertisseur de niveaux de signaux tel que défini en préambule est notamment caractérisé en ce que la deuxième connexion de l'élément de charge peut également être connectée à un second point du circuit à potentiel défini par rapport à celui de la référence commune, en ce que ledit premier point du circuit et, le cas échéant le second point lorsqu'il est distinct du premier point, sont à un potentiel fixé à une valeur égale à celle de la référence commune ou comprise entre cette valeur et celle de ladite autre borne de la seconde alimentation continue, en ce qu'entre la base du transistor émetteur suiveur et la borne de transit est interposé au moins un élément limiteur de courant, et en ce que l'émetteur du transistor émetteur suiveur est directement connecté à la source de courant constant ce noeud, commun avec ladite première connexion de l'élément de charge, constituant une borne de sortie du convertisseur portant les signaux convenant à une entrée de la seconde logique, signaux dont un niveau est determiné, à partir du potentiel dudit premier point du circuit, ou le cas échéant à partir dudit second point, par la chute de tension dans l'élément de charge parcouru par le courant de la source de courant constant, le transistor émetteur suiveur étant bloqué, alors que l'autre niveau est déterminé par le potentiel de l'émetteur du transistor émetteur suiveur, celui-ci étant alors conducteur.

Le circuit convertisseur selon l'invention offre l'avantage d'être constitué d'un nombre restreint d'éléments qui sont facilement intégrables au sein de ladite seconde logique. Le circuit ne comporte pas de borne de la première alimentation continue telle que le $+V_{cc}$ dans le cas où la première logique est constituée par de la TTL.

2

Les potentiels de valeurs comprises entre les bornes de la première alimentation continue sont délivrés au circuit convertisseur uniquement par la borne de transit. On réalise donc une économie dans le nombre de broches d'un circuit intégré de la seconde logique qui incorpore un tel convertisseur.

Enfin, et comme il sera, par la suite, exposé en détail, les excursions entre niveaux des signaux d'entrée et de sortie du circuit convertisseur peuvent être maintenues compatibles dans une très large gamme de température.

Avantageusement, la base du transistor émetteur suiveur est reliée à la borne de transit via un branchement série comportant une résistance limitatrice de courant et au moins une jonction semiconductrice supplémentaire en direct.

Dans un premier mode de mise en oeuvre de l'invention, le collecteur du transistor émetteur suiveur est connecté à l'un des noeuds dudit branchement série.

A titre d'exemple, si le branchement série est constitué successivement, à partir de la borne de transit, de la résistance limitatrice et de la jonction semiconductrice supplémentaire, le collecteur du transistor émetteur suiveur peut être connecté à volonté, soit directement à la borne de transit, soit au noeud reliant la résistance limitatrice à la jonction semiconductrice supplémentaire, soit encore directement à la base du même transistor. Cependant, l'ordre des éléments du branchement série peut encore être inversé et le choix pour la connexion du collecteur demeure.

Comme on le verra en détail par la suite, la valeur de la résistance limitatrice doit être choisie différemment selon que le courant de collecteur du transistor émetteur suiveur traverse ou non cette résistance.

Dans ce mode de mise en oeuvre très simple, la borne de transit qui fournit les signaux de commande pour la base du transistor émetteur suiveur fournit également le courant de collecteur de ce transistor lorsqu'il y a lieu.

Le premier mode de mise en oeuvre de l'invention comporte une variante particulière selon laquelle une résistance limitatrice additionnelle est insérée dans ledit branchement série entre le noeud auquel est connecté le collecteur du transistor émetteur suiveur et la base dudit transistor. Cette variante offre l'avantage de réduire le courant fourni par la borne de transit.

Dans un deuxième mode de mise en oeuvre de l'invention, le circuit convertisseur se caractérise par le fait que ledit premier point du circuit est connecté à une première électrode d'une jonction semiconductrice annexe, jonction dont la seconde électrode est connectée à la référence commune, une source annexe de courant étant, par ailleurs, branchée entre la première électrode de la jonction semiconductrice annexe et ladite autre borne de la seconde alimentation, qui soumet la jonction semiconductrice annexe à un courant en sens direct, et que ledit branchement série comporte deux jonctions semiconductrices supplémentaires.

Ce mode de mise en oeuvre consiste donc à décaler de la valeur d'une chute de tension directe d'une jonction semiconductrice la commande de la base du transistor émetteur suiveur par rapport au premier mode de mise en oeuvre. Il s'ensuit que l'on peut alors avantageusement connecter le collecteur du transistor émetteur suiveur à la référence commune. Le courant collecteur est alors fourni par la référence commune et non plus par la borne de transit, ce qui réduit la consommation de courant sur cette borne.

Une variante particulièrement avantageuse pour le deuxième mode de mise en oeuvre de l'invention, mais qui est également applicable au premier mode, consiste en ce qu'une source additionnelle de courant, notamment une résistance de base additionnelle est branchée entre la base du transistor émetteur suiveur et ladite autre borne de la seconde alimentation. Cette source additionnelle de courant, choisie pour délivrer un courant faible par rapport à celui délivré par ladite source de courant constant permet de réduire l'influence du gain du transistor émetteur suiveur sur le fonctionnement du circuit convertisseur au point que cette influence devienne négligeable.

Selon une première variante du deuxième mode de mise en oeuvre de l'invention, ledit second point du circuit à potentiel défini est connecté audit premier point.

Selon une deuxième variante de ce même mode de mise en oeuvre du circuit selon l'invention l'élément de charge est constitué par un transistor de même polarité que le transistor émetteur suiveur, appelé ci-après transistor de charge, ledit transistor de charge ayant son émetteur constituant ladite première connexion et sa base constituant ladite deuxième connexion, circuit dans lequel la borne de transit peut recevoir en outre, pour un transfert vers la première logique, des signaux provenant d'un circuit de sortie de la seconde logique comportant une première paire de transistors à émetteurs couplés montés en porte "OU" pour la commande d'un premier transistor d'une seconde paire de transistors à émetteurs couplés, se caractérise en ce que l'une des bases de la première de transistors constitue une première entrée de sélection de mode de conversion, l'autre base de la même paire recevant les signaux de la seconde logique, en ce que, dans la liaison du collecteur du premier transistor de la seconde paire vers la référence commune, est insérée une jonction semiconductrice qui constitue ladite jonction semiconductrice annexe tandis qu'une source de courant alimentant la seconde paire constitue ladite source annexe de courant, en ce que le collecteur du second transistor de la seconde paire est relié à la référence commune via une jonction semiconductrice en direct et, d'autre part, est connecté à la borne de transit, et en ce que la base du transistor de charge constitue une seconde entrée de sélection de mode, commandée complémentairement par rapport à la première entrée de sélection. Un tel circuit convertisseur peut donc s'appliquer à la conversion bidirectionnelle des signaux entre les deux logiques, n'utilisant qu'une seule borne de transit.

3

D'autres particularités, détails et avantages de l'invention seront mis en évidence par la description donnée ci-après, en référence aux dessins annexés, pour des exemples fournis à titre non limitatif qui feront bien comprendre comment l'invention peut être réalisée.

La figure 1 montre un schéma électrique général du circuit convertisseur selon l'invention ainsi que ses liaisons principales vers la première et la seconde logique.

La figure 2 est un schéma électrique du circuit convertisseur selon un premier mode de mise en oeuvre de l'invention.

La figure 3 montre un schéma d'un circuit comportant des variantes par rapport à celui de la figure 2.

La figure 4 représente le schéma électrique du circuit convertisseur selon un deuxième mode de mise en oeuvre de l'invention.

La figure 5 montre une variante du schéma de la figure 4 appliquée au cas où le circuit convertisseur selon l'invention est utilisé pour une conversion bidirectionnelle des signaux entre les deux logiques.

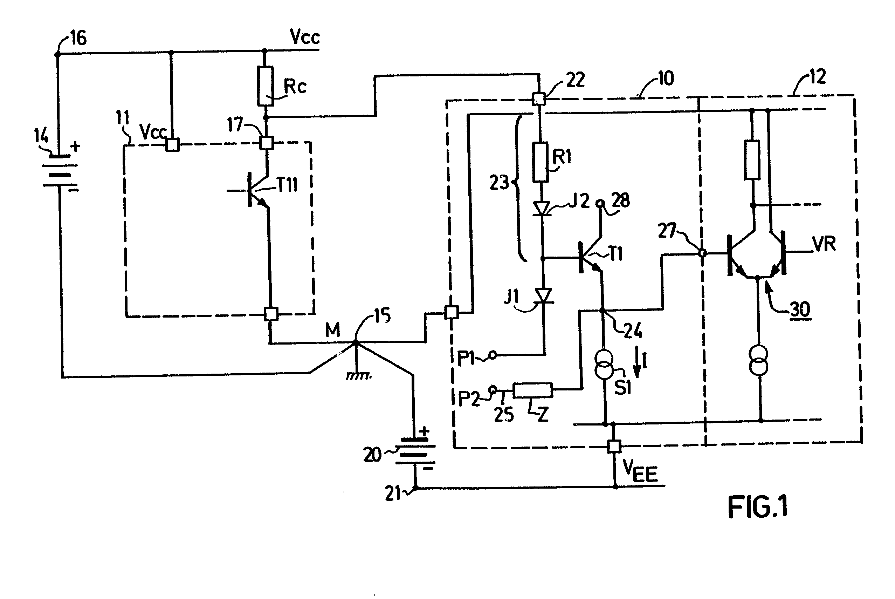

A la figure 1, le circuit convertisseur 10 est représenté par un schéma général entouré d'un cadre en tirets. Un circuit d'une première logique 11, de type saturée, TTL par exemple, est alimenté à partir d'une première alimentation continue 14 dont la borne négative 15 constitué la référence commune de potentiel M. Le potentiel communément appelé $V_{cc}$ est délivré par la borne positive 16 de l'alimentation 14. Un circuit d'une seconde logique 12, de type non saturée comme la logique ECL ou CML, est délimité par un cadre en tirets repéré par 12, cadre qui est représenté accolé au circuit convertisseur 10 du fait que les circuits 10 et 12 sont intégrés de préférence simultanément dans le même corps semiconducteur. Le circuit de la seconde logique 12 est alimenté par une seconde alimentation continue 20, dont la borne positive est à la référence commune de potentiel M. Le potentiel, communément appelé $V_{EE}$, est délivré par la borne négative 21 de l'alimentation 20. Les signaux de sortie du circuit de la première logique 11 sont présents sur la borne de sortie 17 qui est reliée au $V_{cc}$ via une résistance $R_c$, externe au circuit 11, résistance servant de charge au collecteur d'un transistor T11 en sortie du circuit 11.

La borne de sortie 17 est connectée à une borne de transit 22 appartenant au circuit convertisseur 10. Le circuit convertisseur 10 comporte un transistor émetteur suiveur T1 dont la base est, d'une part, reliée à un premier point P1 du circuit 10 à potentiel défini par rapport à celui de la référence commune M, via une première jonction semiconductrice J1 montée dans le sens direct et, d'autre part, reliée à la borne de transit 22 via un branchement série 23 comportant notamment une résistance R1, limitatrice de courant, et au moins une jonction semiconductrice supplémentaire J2, montée dans le sens direct. Pour la clarté de la figure, les jonctions semiconductrices J1 et J2 ont ont été représentées comme des diodes mais il est clair que, pour le spécialiste, on utilise avantageusement en tant que jonctions semiconductrices J1 et J2 des transistors connectés en diode. Cette remarque s'étend également à d'autres jonctions semiconductrices dont il sera question dans la suite de l'exposé.

Le circuit convertisseur 10 comporte encore une source de courant constant S1 de structure habituelle en technique ECL/CML notamment, branchée entre $V_{EE}$ et l'émetteur du transistor émetteur suiveur T1. La source de courant constant S1 délivre un courant de valeur I.

Le circuit convertisseur 10 comporte enfin un élément de charge Z dont une première connexion 24 est reliée à l'émetteur du transistor émetteur suiveur T1, et une deuxième connexion 25 est reliée à un second point P2 du circuit 10 à potentiel défini par rapport à celui de la référence commune M.

La borne de sortie 27 du circuit convertisseur 10 est commune à la première connexion 24 de l'élément de charge Z. La borne de sortie 27 porte les signaux pour l'entrée du circuit de la seconde logique 12. Ces signaux ont leur niveau bas déterminé, à partir du potentiel du second point P2, par la chute de tension dans l'élément de charge Z parcouru par le courant I, le transistor émetteur suiveur T1 étant bloqué en réponse à un niveau bas de la borne de transit 22, alors que le niveau haut des signaux portés par la borne de sortie 27 est déterminé par le potentiel de l'émetteur du transistor émetteur suiveur T1 lorsque celui-ci est conducteur, en réponse à un niveau haut de la borne de transit 22. Le niveau haut de la borne de sortie 27 correspond très sensiblement au potentiel du premier point P1 étant donné que la jonction semiconductrice J1 équilibre pratiquement la tension $V_{BE}$ du transistor émetteur suiveur T1.

Comme il sera exposé ci-après, la borne 28 du collecteur du transistor T1 peut être reliée à l'un ou l'autre noeud convenable du circuit 10 selon les cas, noeud choisi pour qu'en régime de conduction, le transistor T1 puisse débiter un courant émetteur de valeur pratiquement égale à I, tout en évitant la saturation.

En ce qui concerne le circuit de la seconde logique 12, on s'est contenté, pour mémoire, de représenter un étage différentiel d'entrée 30 pour lequel le signal porté par la borne 27 est appliqué sur l'une des bases d'entrée, l'autre base étant portée à un potentiel de référence $V_R$. La structure du circuit de la seconde logique 12 relève en effet du domaine de l'art connu, notamment pour le type de logique ECL/CML, et ne fait pas partie de l'invention.

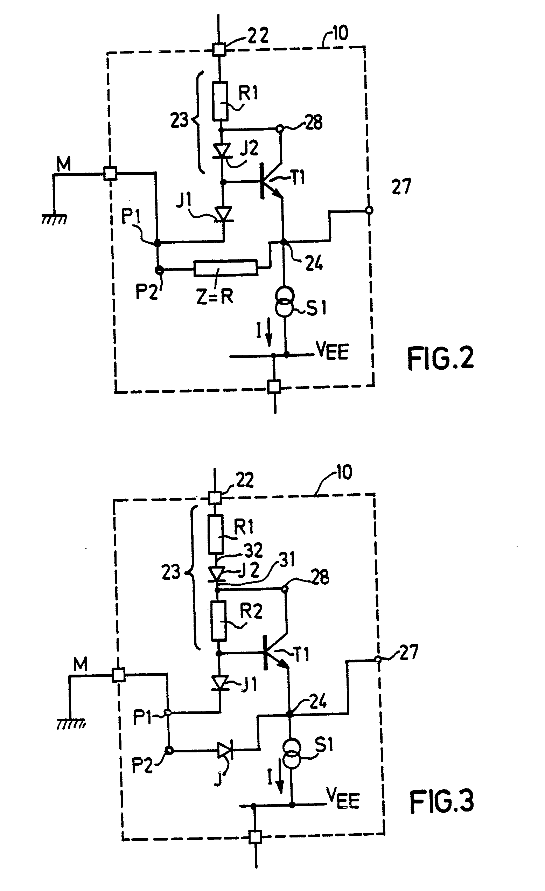

La figure 2 reprend le schéma électrique du circuit convertisseur de la figure 1 dont les éléments communs sont affectés des mêmes repères, et indique un premier mode de mise en oeuvre de l'invention. Le schéma de la figure 2 se distingue de la partie correspondante de la figure 1 par les connexions suivantes: les points P1 et P2 sont connectés ensemble à la référence commune M et la borne de collecteur 28 du transistor T1 est connectée au branchement série 23 sur le conducteur qui relie la résistance R1 et la jonction semiconductrice J2. Par ailleurs, dans cet exemple, on a choisi d'exposer le cas où l'élément de charge Z est constitué par une résistance de valeur R.

4

On explique le fonctionnement du circuit convertisseur 10 de la figure 2 en supposant d'abord que la borne de transit 22 est à l'état bas. Pour une logique TTL par exemple, ceci signifie que le potentiel de la borne de transit 22 est à un potentiel inférieur à +0,4 volt environ. Comme déductible de la figure 1, ce niveau bas est déterminé par la mise en saturation du transistor T11 chargé par la résistance $R_C$. Dans ces conditions, le transistor T1 est bloqué et le courant I traverse l'élément de charge Z=R créant sur la borne 27 un état bas dont le potentiel est égal à: (0−RI) volt. On choisit à volonté R et I de sorte que leur produit conduise à une chute de tension de valeur égale à l'excursion de tension désirable à l'entrée du circuit de la seconde logique 12. Par exemple, on choisira I=0,5 mA, R≃800 Ω pour une logique CML dont l'excursion de tension est voisine de 0,4 volt. On pourrait tout aussi bien choisir R≃1,6 KΩ dans le cas d'une entrée sur logique ECL dont l'excursion de tension d'entrée est voisine de 0,8 volt. Il est aisé de vérifier maintenant qu'à l'état bas de la borne de transit 22, la chute de tension entre cette borne et la borne 27 est insuffisante pour débloquer le transistor T1.

On suppose maintenant que le potentiel de la borne de transit 22 est remonté jusqu'à ce que, le transistor T1 étant débloqué, il délivre un courant sur son émetteur de valeur égale à I/2. L'élément de charge est parcouru également par un courant de valeur I/2 provenant de la source de courant constant S1. Le potentiel $V_T$ atteint alors par la borne de transit 22 sera défini arbitrairement comme niveau de basculement de la première logique tandis que le potentiel atteint par la borne de sortie 27 du convertisseur sera défini comme niveau de basculement de la seconde logique. $V_T$ peut être évalué approximativement au moyen de l'expression (1):

$$V_T \simeq R1 \cdot I/2 + V_{J2} + V_{BE}(T1) - R \cdot I/2$$

dans laquelle la valeur du courant de base a été négligée devant celle des courants émetteur et collecteur du transistor T1, valeurs prises comme égales entre elles. Dans l'expression (1), $V_{J2}$ désigne la chute de tension directe dans la jonction semiconductrice J2, tandis que $V_{BE}(T1)$, celle du transistor T1 dans la jonction émetteur base. On voit immédiatement qu'en choisissant R1=R, le niveau de basculement de la première logique devient très voisin de deux chutes de tension directe de jonctions et comporte une variabilité correspondante en fonction de la température.

On sait qu'une logique TTL est caractérisée par un niveau de basculement dont la valeur, de l'ordre de 1,3 volt, varie selon la température comme deux chutes de tension de jonctions. On obtient donc par le circuit convertisseur de l'exemple décrit la compatibilité des niveaux de basculement souhaitable, en fonction de la température, entre les deux logiques puisque le niveau de basculement en sortie reste stable comme cela convient pour une logique CML. On pourrait d'ailleurs obtenir aisément toute autre variabilité souhaitable en fonction de la température, soit en ajoutant une ou plusieurs jonctions en direct dans le branchement série 23 pour accroître la variabilité du niveau d'entrée , soit en intercalant une ou plusieurs jonctions en direct entre la borne 24 et la borne 27, par exemple, pour accoître la variabilité du niveau de sortie.

On considère maintenant que le potentiel de la borne de transit monte au-delà du niveau de basculement vers l'etat haut de la première logique. Le courant émetteur du transistor T1 augmente jusqu'à ce qu'il atteigne la valeur de I. Le courant dans R est alors annulé et la borne 27 atteint l'état haut, à 0 volt. Pour les potentiels supérieurs de la borne de transit 22, la jonction semiconductrice J1 entre en conduction et l'état haut de la borne 27 est maintenu à 0 volt. A l'état haut de la borne de transit 22, le courant d'entrée du circuit 10 est limité par la résistance limitatrice R1.

La figure 3 illustre un circuit convertisseur analogue à celui de la figure 2, mais comportant quelques variantes. Les éléments communs aux figures 1 et 2 y sont affectés des mêmes signes de référence. Le circuit de la figure 3 se distingue en ce que la résistance limitatrice R1 étant connectée directement à la borne de transit, le collecteur du transistor émetteur suiveur T1 connecté à une première électrode 31 de la jonction semiconductrice J2, une résistance limitatrice additionnelle R2 est insérée dans le branchement série 23 entre la première électrode 31 de la jonction J2 et la base du transistor T1. La seconde électrode 32 de la jonction J2 est connectée à la résistance limitatrice R1. Une autre variante par rapport à la figure 2 réside dans le fait que l'élément de charge pour la source de courant S1 est une jonction semiconductrice J, branchée dans le sens direct relativement à cette source de courant.

Le circuit de la figure 3 fonctionne de manière assez semblable à celle du circuit de la figure 2. Lorsque le potentiel de la borne de transit 22 est à l'état bas, le transistor T1 est bloqué. Le courant I traverse la jonction J créant sur la borne 27 un état bas dont le potentiel est égal à: (0−$V_J$) volt, $V_J$ désignant la chute de tension directe dans la jonction J traversée par le courant I. La valeur ($V_J$) représente également l'excursion de niveau à l'entrée de la seconde logique, soit 0,7 à 0,8 volt selon la valeur du courant I et les caractéristiques de la jonction J qui ont été choisies.

Lorsque le potentiel de la borne de transit 22 est remonté à partir de l'état bas, une fraction croissante du courant I est délivrée par l'émetteur du transistor T1 et le potentiel de la borne de sortie 27 s'élève. Lorsqu'il atteint la valeur de −$V_J$/2, valeur définie comme niveau de basculement pour l'entrée de la seconde logique, il est facile de vérifier que la fraction du courant I passant dans la jonction J est extrêmement petite, et que l'essentiel du courant I est alors fourni par l'émetteur du transistor T1. Dans ces conditions, le potentiel $V_T$ atteint par la borne de transit 22 est évalué approximativement au moyen de la relation (2):

$$V_T \simeq R1 \cdot I + V_{J2} + R2 \cdot \frac{I}{\beta} + V_{BE}(T1) - V_J/2$$

dans laquelle on a négligé un terme en $R1 \cdot I/\beta$, le gain $\beta = I_E(T1)/I_B(T1)$ étant élevé en général.

On peut alors choisir des valeurs de résistances telles que:

$$R1 \simeq V_J/2I - R2/\beta$$

de sorte que le niveau de basculement de la première logique soit à nouveau voisin de deux chutes de tension directes de jonctions et implique une variabilité correspondante en fonction de la température. Il y a lieu d'observer que le terme $V_J/2$ représente en fait un niveau de tension que l'on désire assurer constant lorsque la température varie puisqu'il a été choisi comme valeur de niveau de basculement de la seconde logique. En outre, il est aisé de choisir une valeur de $R_2$ assez élevée pour que le courant d'entrée sur la borne de transit 22, à l'état haut, soit réduit significativement par rapport à l'effet de la résistance R1 utilisée seule (comme dans le cas du circuit de la figure 2) mais, toute-fois, de valeur pas tellement élevée au point de rendre le niveau de basculement à l'entrée du convertisseur, fortement dépendant du gain $\beta$ du transistor T1. L'introduction de la résistance limitatrice additionnelle R2 offre donc l'avantage de pouvoir réduire sensiblement le courant d'entrée du circuit 10 à l'état haut, alors que la valeur de la résistance R1 reste le paramètre prépondérant qui détermine l'ajustement du niveau de basculement de la première logique. Il est clair que l'introduction de la résistance limitatrice additionnelle R2, considérée comme une première variante par rapport au schéma de la figure 2, est une variante qui n'est pas liée à la deuxième variante qui a consisté à utiliser, en tant qu'élément de charge, une jonction J au lieu d'une résistance R.

La troisième variante introduite à la figure 3 réside dans le choix du point où le collecteur du transistor T1 a été connecté au branchement série 23 qui est différent de celui représenté à la figure 2.

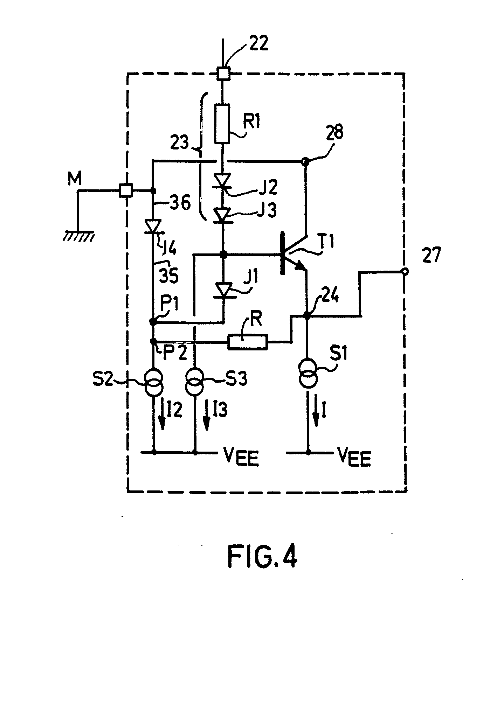

La figure 4 présente l'exemple d'un deuxième mode de mise en oeuvre du circuit convertisseur selon l'invention, tel que défini par le schéma général de la figure 1. Les éléments communs à ceux de la figure 1 sont affectés des mêmes signes repères.

Le schéma de la figure 4 se distingue de la partie correspondante de la figure 1 par les points suivants:

— les points P1 et P2 sont connectés ensemble à une première électrode 35 d'une jonction semiconductrice annexe J4, tandis que la seconde électrode 36 de cette jonction est connectée à la référence commune M. La jonction J4 est soumise à un courant en sens direct, d'une source de courant S2 annexe, branchée entre la première électrode 35 de la jonction J4 et la ligne d'alimentation $V_{EE}$. La source de courant S2 est choisie pour débiter un courant I2 de valeur nettement supérieure à celle du courant I de la source de courant S1.

Ainsi, au cours du fonctionnement, la jonction J4 est toujours alimentée, ce qui aboutit à ce que les points P1 et P2 soient constamment à un potentiel inférieur à la référence commune M, potentiel décalé de celui-ci de la valeur d'une chute de tension directe de jonction,

— par ailleurs, le branchement série 23 comporte deux jonctions semiconductrices supplémentaires J2 et J3 au lieu d'une seule comme aux figures 1 à 3,
— d'autre part, la borne de collecteur 28 du transistor T1 est connectée directement à la référence commune M,
— enfin, une source de courant additionnelle S3 est branchée entre la base du transistor T1 et la ligne d'alimentation $V_{EE}$. La source de courant S3 est dimensionnée pour délivrer un courant I3 dont la valeur est avantageusement choisie comme comprise entre celles de I et I/$\beta$. La source de courant S3 peut être constituée par une simple résistance de base de valeur élevée et reliée à $V_{EE}$.

Dans l'exemple de la figure 4, l'élément de charge pour la source de courant S1 est une résistance R. Le fonctionnement du circuit convertisseur de cet exemple est maintenant expliqué brièvement: lorsque la borne de transit 22 est à l'état bas, le transistor T1 est bloqué. En effet, le décalage du potentiel de la base de T1, dû à la chute de tension dans la jonction J4, est compensé par la jonction supplémentaire J3. De plus, la source de courant S3 a pour effet de renforcer le blocage de T1. La borne de sortie 27 est à l'état bas dont le potentiel est égal à $(-V_{J4} - R.I)$, soit une excursion de niveau de la deuxième logique définie par le terme $R \cdot I$, décalée négativement d'une chute de tension directe de la jonction J4. On notera qu'en raison du décalage dû à $-V_{J4}$, le signal de sortie du convertisseur 10 sera appliqué à un étage de la seconde logique dont l'autre entrée est soumise à une référence également décalée négativement d'une chute de tension directe de jonction, comme cela est connu dans la technique ECL/CML.

Lorsque le potentiel de la borne de transit 22 est remonté à partir de l'état bas, le potentiel de la base de T1 remonte jusqu'à ce que la trajet base-collecteur du transsistor T1 commence à conduire.

On examine maintenant la situation pour laquelle le courant délivré par l'émetteur de T1 soit égal à I/2. L'élément de charge R est, à cet instant, également parcouru par un courant égal à I/2. La borne de sortie est alors à un niveau défini comme niveau de basculement de la seconde logique. Le potentiel $V_T$ atteint alors par la borne de transit 22 peut être évalué approximativement par l'expression (3):

(3)
$$V_T \simeq R1 \cdot (I3+I/2\beta)+V_{J2}+V_{J3}+V_{BE}(T1)-R \cdot I/2-V_{J4}$$

expression qui peut encore se résumer à:

$$V_T \simeq R1 \cdot (I3+I/2\beta)-R \cdot I/2+2 \cdot V_J$$

où $V_J$ désigne une chute de tension de jonction en direct.

Si on désire, comme dans le cas où la première logique est de type TTL, que le niveau de basculement de cette première logique se place à: $V_T \simeq 2 \cdot V_J$, on obtient alors: $R1(2I3/I+1/\beta) \simeq R$

En reprenant les valeurs numériques déjà utilisées à propos de l'exemple de la figure 2, I=0,5 mA, R=800 Ω et en choisissant I3=0,1 mA, on obtient R1≃2KΩ, le terme 1/β étant de peu d'importance comparé à 2I3/I qui vaut alors 0,4.

On comprend aisément de ce qui précède pourquoi la présence de la source de courant additionnelle S3 est avantageuse dans les cas où le courant collecteur du transistor T1 ne traverse pas la résistance R1, comme dans cet exemple. On aurait, en l'absence de la source de courant S3, une valeur de résistance R1 qui devrait alors être choisie en fonction du gain β du transistor T1.

Lorsque le potentiel de la borne de transit 22 est remonté vers le niveau haut de la première logique, le courant traversant la résistance R s'annule et la borne 27 est portée à l'état haut, de valeur égale à $-V_{J4}$. On remarque que la consommation de courant sur la borne de transit 22 à l'état haut est réduite par rapport aux exemples précédents, du fait que le courant collecteur de T1 est maintenant prélevé à la référence commune M et que la résistance R1 a une valeur plus élevée.

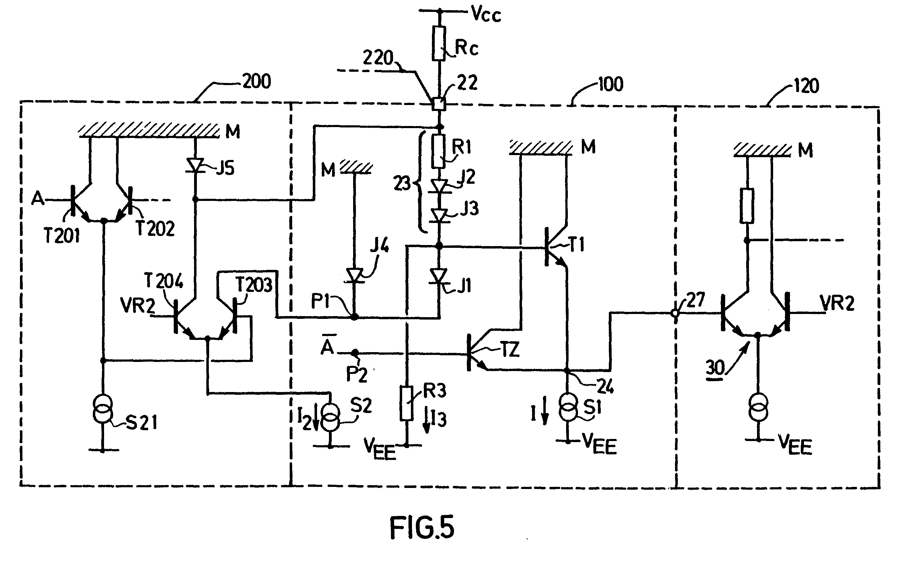

La figure 5 montre un autre exemple du circuit convertisseur selon l'invention, dont la structure est proche de celle de l'exemple de la figure 4, mais dans une application à une conversion bidirectionnelle de signaux entre les deux logiques. Les éléments de la figure 5 qui sont communs à ceux de la figure 4 sont affectés de repères identiques dans la mesure où ils remplissent une fonction similaire.

Dans cet exemple, on considère la conversion bilatérale de signaux entre une logique TTL (non représentée) dont les signaux d'entrée ou de sortie parviennent à la borne de transit 22 par le bus 220 et une logique CML. Le bus 220 est chargé par la résistance $R_C$ connectée à $V_{CC}$. La logique CML, au sein de laquelle le circuit convertisseur 100 a été physiquement intégré, est une logique à fonction complexe, par exemple un réseau de portes prédiffusé ou une mémoire. On n'en a représenté que les portions relatives à l'invention, à savoir: un circuit CML d'entrée 120 pour l'entrée des signaux provenant de la logique TTL après conversion des niveaux par le convertisseur 100, et un circuit CML de sortie 200 pour la sortie des signaux provenant de la logique CML et destinés à la logique TTL. Le transit de ces signaux est effectué par l'unique borne de transit 22.

Le circuit CML de sortie 200 comporte une première paire de transistors T201, T202 à émetteurs couplés, montés en porte "OU" pour la commande d'un transistor T203 formant, avec un transistor T204, une seconde paire.

Les collecteurs des transistors T201 et T202 sont connectés à la masse M (référence commune des deux logiques). Le conducteur commun des émetteurs est relié au $V_{EE}$ via une source de courant S21 et, d'autre part, connecté à la base du transistor T203.

La base du transistor T204 est portée à un niveau de potentiel de référence $V_{R2}$ de la logique CML, connu sous le nom de "deuxième niveau" en raison de sa valeur imposée par la situation de la deuxième paire de transistors relativement à la première paire. Le collecteur du transistor T204 est relié à la masse M via une jonction semiconductrice J5 en direct et, d'autre part, connecté à la borne de transit 22. Le collecteur du transistor T203 est connecté au point P1 du circuit convertisseur 100, lequel est relié à la masse M via la jonction semiconductrice J4 qui constitue la jonction semiconductrice annexe décrite à propos de la figure 4. Le conducteur commun aux émetteurs de la seconde paire de transistors T203, T204 est relié à $V_{EE}$ via une source de courant S2 représentée au sein du circuit convertisseur 100, car elle remplit la fonction de la source annexe de courant S2 de l'exemple de la figure 4.

A la base du transistor T202, sont appliqués des signaux provenant de la logique CML et qui sont destinés à être transférés en tant que signaux d'entrée TTL sur la bus 220.

La base du transistor T201 constitue une première entrée de sélection de mode de conversion, qui est soumise à un signal de sélection A.

Le circuit convertisseur 100 est analogue au circuit 10 de la figure 4 à quelques différences près.

En premier lieu, l'élément de charge de la source de courant S1 est constitué ici par un transistor $T_Z$ au lieu d'une résistance. Le transistor de charge $T_Z$ est de même polarité que le transistor émetteur suiveur T1. Son émetteur constitue ce que l'on a appelé précédemment la première connexion de l'élément de charge, sa base constitue la deuxième connexion reliée au point P2 qui est soumis au potentiel d'un des niveaux internes CML. Plus précisément, au point P2, et donc à la base du transistor $T_Z$, est appliqué un signal $\bar{A}$ complémentaire du signal de sélection de mode A dont les niveaux sont définis par rapport à $V_{R1}$, référence de "premier niveau". La base de $T_Z$ constitue donc une seconde entrée de sélection de mode, commandée complémentairement par rapport à la première entrée de sélection.

7

**0 109 106**

En second lieu, la source additionnelle de courant est constituée ici par une simple résistance de base additionnelle R3, de forte valeur, en remplacement de la source additionnelle de courant S3 décrite à la figure 4. Cette résistance R3 est branchée entre la base du transistor T1 et $V_{EE}$.

La borne de sortie 27 du circuit convertisseur 100 porte des signaux qui, issus de la logique TTL et après conversion, sont appliqués au circuit CML d'entrée 120 dont on n'a représenté que le premier étage différentiel 30. Cet étage est, par ailleurs, référencé à $V_{R2}$, référence de deuxième niveau.

Le fonctionnement des circuits de la figure 5 est maintenant brièvement décrit. Lorsque le signal de sélection A est à l'état haut, le transistor T201 conduit, le transistor T203 conduit également, et ce de manière indépendante du signal appliqué sur la base du transistor T202. La jonction J4 est alimentée par le courant de la source de courant S2 via le transistor T203. Le transistor T204 est bloqué, son collecteur constitue une impédance élevée pour la borne de transit 22 qui est alors libre de recevoir par le bus 220 les signaux provenant de la logique TTL. Un signal de sélection A à l'état haut est donc un signal sélectionnant le mode: sortie TTL vers entrée CML.

Le signal $\overline{A}$ appliqué à P2 est alors à l'état bas, de l'ordre de $-0,4$ volt. Si, dans ces circonstances, la borne de transit 22 est à l'état bas, le transistor T1 ne conduit pas. Le courant I de la source de courant S1 traverse le transistor de charge $T_z$ créant sur la borne 27 un état bas dont le potentiel est égal à $(-0,4-V_{BE(TZ)})$ volt, soit environ $-1,2$ volt. $V_{BE(TZ)}$ désigne la chute de tension émetteurbase du transistor de charge $T_z$.

Lorsque le potentiel de la borne de transit 22 est remonté à partir de l'état bas, le potentiel de la base de T1 remonte si bien que ce transistor commence à conduire. Une fraction croissante du courant I est délivrée par l'émetteur de T1, fraction qui est déduite du courant traversant le transistor de charge $T_z$. Le potentiel de la borne 27 commence à croître.

Lorsque le potentiel de la borne 27 aura atteint une valeur égale à $V_{R2}$, le niveau de basculement du premier étage différentiel 30 est obtenu. On vérifie aisément que, dans ces circonstances, la fraction résiduelle du courant I traversant le transistor $T_z$ est très petite devant la fraction de courant I délivrée par le transistor T1. On évalue maintenant quel est le potentiel $V_T$ atteint par la borne de transit 22, moyennant des approximations mentionnées précédemment, au moyen de la relation (3):

(3)
$$V_T \simeq R1 \cdot (I3+I/2\beta)+V_{J2}+V_{J3}+V_{BE(T1)}- \mid V_{R2} \mid$$

On désire que $V_T$ corresponde au niveau de basculement de la logique TTL, soit deux fois la chute de tension directe d'une jonction. On choisit des valeurs telles que:

$$R1(I3+I/2\beta) \simeq \mid V_{R2} \mid -V_{BE(T1)}$$

Mais, comme on le sait, le potentiel de référence de deuxième niveau $V_{R2}$ correspond à la somme d'une chute de tension directe de jonction et d'une demi-excursion de niveau logique CML. On est finalement amené à choisir:

$R1(I3+I/2\beta) \simeq 1/2$ (excursion logique CML) On peut prendre par exemple:

$I=0,5$ mA, $I3=0,1$ mA, ce qui permet de déterminer la valeur de la résistance R3. Une demi-excursion logique CML étant, en général, voisine de $0,2$ volt, on aboutit à $R1 \simeq 1,90$ K$\Omega$ pour un gain $\beta$ de 50, du transistor T1 et $R1 \simeq 1,95$ K$\Omega$ pour un gain $\beta$ de 100. On observe qu'il est facile de choisir des valeurs pour lesquelles le fonctionnement du circuit soit très peu affecté par des variations de gain des transistors, d'un lot à l'autre, lors de la fabrication de circuits selon l'invention, sous une forme intégrée.

Lorsque, maintenant, le potentiel de la borne de transit 22 est remonté au-delà du niveau de basculement, vers l'état haut de la TTL, le transistor de charge $T_z$ cesse de conduire. La borne 27 atteint un état haut fixé par le potentiel de P1 puisque les chutes de tension $V_{J1}$ et $V_{BE(T1)}$ se compensent sensiblement. L'état haut de la borne 27 correspond donc à un potentiel de l'ordre de $-0,8$ volt imposé par le décalage de tension par rapport à la masse M dû à la jonction J4 alimentée en direct.

On examine maintenant le cas où le signal de sélection de mode A est à l'état bas. Son complémentaire $\overline{A}$, appliqué à P2 est à l'état haut, voisin de 0 volt. Le transistor de charge $T_z$ est conducteur et porte la borne 27 à l'état haut, forcé, de $-0,8$ volt, état que le transistor T1 ne peut pas modifier en réponse à un signal porté par la borne de transit 22. Le circuit convertisseur 100 ne peut plus transmettre de signaux provenant de la logique TTL vers le circuit CML 120, dont l'étage différentiel 30 est bloqué à l'état haut sur son entrée. Le signal A à l'état bas étant appliqué à la base du transistor T201, le potentiel du conducteur commun des émetteurs de la paire de transistors T201, T202, suit le signal de la logique CML appliqué à la base du transistor T202, compte tenu du décalage d'un $V_{BE}$.

Lorsque, dans la paire de transistors T203, T204, c'est le transistor T204 qui conduit, le courant I2 de la source de courant S2 est prélevé pour partie sur la borne de transit 22 qui est portée à l'état bas, et pour le reste sur la jonction J5 lorsque l'on a choisi une valeur de courant I2 relativement élevée, soit par exemple: $I2=5$ mA. En prenant $R_c=2,5$ K$\Omega$, la borne de transit 22 est portée à un état bas, de $-0,8$ volt environ, déterminé par la chute de tension par rapport à la masse M, dans la jonction J5.

A cet instant, le transistor T203 ne débite pas; la jonction J4 n'est pas alimentée, mais la borne de transit 22 étant à l'état bas, le transistor T1 reste bloqué.

Lorsque maintenant, c'est le transistor T203 qui conduit, le transistor T204 est bloqué. La borne de transit 22 est libre de remonter à l'état haut sous l'effet de la résistance $R_c$ connectée au $V_{cc}$. Le courant I2 de la source de courant S2 est fourni, via le transistor T203, pour partie par la jonction J1 et pour le reste par la jonction J4. A cet instant, le transistor T1 fonctionne dans les conditions décrites précédemment, c'est-à-dire qu'à supposer qu'il conduise, il imposerait à la borne 27 le même état haut de −0,8 volt que celui déjà fixé par le transistor de charge $T_Z$ commandé par le signal $\overline{A}$ à l'état haut. Un signal de sélection A, à l'état bas, est donc un signal sélectionnant le mode: sortie CML vers entrée TTL.

A la lumière des exemples précédemment décrits, il est clair que des variantes peuvent être apportées sans pour autant sortir du cadre de l'invention. A titre d'exemple, on a décrit plus spécialement le cas de la conversion de signaux entre une logique TTL et une logique ECL/CML qui requiert l'utilisation de transistors de type NPN. Bien entendu, en inversant la polarité des alimentations et en utilisant des transistors PNP, on obtiendrait également un circuit convertisseur répondant à d'autres besoins. Par ailleurs, dans le circuit de la figure 5, on a décrit un exemple particulièrement économique en ce qui concerne le nombre de composants. Il va de soi que d'autres modes de mise en oeuvre de l'invention sont encore possibles. Les valeurs numériques citées à titre d'exemple ainsi que les calculs n'ont été indiqués que pour guider le spécialiste dans le choix nécessaire des éléments à utiliser.

**Revendications**

1. Circuit convertisseur (10) de niveaux de signaux entre, d'une part une première logique (11) de type saturée à deux niveaux de signaux de sortie, alimentée par une première alimentation continue (14) dont une des bornes (15) constitue la référence commune de potentiel (M) et, d'autre part une seconde logique (12) de type non saturée à deux autres niveaux de signaux, alimentée par une seconde alimentation continue (20) dont une des bornes est connectée à la référence commune de potentiel (M), et l'autre borne (21) est à une tension de polarité opposée à celle de l'autre borne de la première alimentation coninue, une borne de transit (22) recevant les signaux de sortie de la première logique (11) pour être convertis en signaux aux niveaux convenables pour l'entrée de la seconde logique, circuit convertisseur comportant un transistor émetteur suiveur (T1) dont la base est reliée à un premier point du circuit (P1) à potentiel défini par rapport à celui de la référence commune (M), via une première jonction semiconductrice (J1) en sens direct, et reçoit d'autre part les signaux de sortie de la première logique à partir de la borne de transit (22), dont l'émetteur, d'une part est soumis à l'effet d'une source de courant constant (S1), connectée par ailleurs à ladite autre borne ($V_{EE}$) de la seconde alimentation (20), et d'autre part est connecté à une première connexion (24) d'un élément de charge (Z) pour la source de courant constant (S1), tandis que la deuxième connexion (25) de cet élément (Z) est connectée au premier point du circuit (P1) à potentiel défini, caractérisé en ce que ledit premier point du circuit (P1) est à un potentiel fixé à une valeur égale à celle de la référence commune (M) ou comprise entre cette valeur et celle de ladite autre borne (21) de la seconde alimentation continue (20), en ce qu'entre la base du transistor émetteur suiveur (T1) et la borne de transit (22) est disposé en série au moins un élément (R1) limiteur de courant, et en ce que l'émetteur du transistor émetteur suiveur (T1) est directement connecté à la source de courant constant (S1), ce noeud qui est commun avec ladite première connexion (24) de l'élément de charge constituant une borne de sortie du convertisseur portant les signaux convenant à une entrée de la seconde logique, signaux dont un niveau est déterminé, à partir du potentiel dudit premier point du circuit (P1), par la chute de tension dans l'élément de charge (Z) parcouru par le courant (I) de la source de courant constant (S1), le transistor émetteur suiveur (T1) étant bloqué, alors que l'autre niveau est déterminé par le potentiel de l'émetteur du transistor émetteur suiveur (T1), celui-ci étant alors conducteur.

2. Circuit convertisseur (100) de niveaux de signaux entre, d'une part une première logique (11) de type saturée à deux niveaux de signaux de sortie, alimentée par une première alimentation continue (14) dont une des bornes (15) constitue la référence commune de potentiel (M) et, d'autre part une seconde logique (120) (200) de type non saturée à deux autres niveaux de signaux, alimentée par une seconde alimentation continue (20) dont une des bornes est connectée à la référence commune de potentiel (M), et l'autre borne (21) est à une tension de polarité opposée à celle de l'autre borne de la première alimentation continue, une borne de transit (22) recevant les signaux de sortie de la première logique (11) pour être convertis en signaux aux niveaux convenables pour l'entrée de la seconde logique, circuit convertisseur comportant un transistor émetteur suiveur (T1) dont la base est reliée à un premier point (P1) à potentiel défini par rapport à celui de la référence commune (M) via une première jonction semiconductrice (J1) en sens direct et reçoit d'autre part les signaux de sortie de la première logique à partir de la borne de transit (22), dont l'émetteur, d'une part est soumis à l'effet d'une source de courant constant (S1) connectée par ailleurs à ladite autre borne ($V_{EE}$) de la seconde alimentation (20) et d'autre part est connecté à une première connexion (24) d'un élément de charge (TZ) pour la source de courant constant (S1), caractérisé en ce que la deuxième connexion de cet élément de charge (TZ) est connectée à un second point du circuit (P2) à potentiel défini par rapport à celui de la référence commune (M), en ce que lesdits premier et second points du circuit (P1), (P2) sont à un potentiel fixé à une valeur égale à celle de la référence commune (M) ou comprise entre cette valeur et celle de ladite autre borne (21) de la seconde alimentation continue (20), en ce qu'entre la base du transistor émetteur suiveur (T1) et la borne de transit (22) est interposé au moins un élément (R1) limiteur de courant, et en ce que l'émetteur du transistor émetteur suiveur (T1) est directement connecté à la source de courant constant (S1), ce noeud, commun avec ladite première connexion (24) de l'élément de charge,

constituant une borne de sortie du convertisseur portant les signaux convenant à une entrée de la seconde logique, signaux dont un niveau est déterminé, à partir du potentiel dudit second point du circuit (P2), par la chute de tension dans l'élément de charge (TZ) parcouru par le courant (I) de la source de courant constant (S1), le transistor émetteur suiveur (T1) étant bloqué, alors que l'autre niveau est déterminé par le potentiel de l'émetteur du transistor émetteur suiveur (T1), celui-ci étant alors conducteur.

3. Circuit selon l'une des revendications 1 ou 2, caractérisé en ce que la base du transistor émetteur suiveur (T1) est reliée à la borne de transit (22) via un branchement série (23) comportant une résistance limitatrice (R1) de courant et au moins une jonction semiconductrice supplémentaire (J2) en direct.

4. Circuit selon la revendication 3, caractérisé en ce que le collecteur (28) du transistor émetteur suiveur (T1) est connecté à l'un des noeuds dudit branchement série (23).

5. Circuit selon la revendication 4, caractérisé en ce qu'une résistance limitatrice additionnelle (R2) est insérée dans ledit branchement série (23) entre le noeud auquel est connecté le collecteur (28) du transistor émetteur suiveur (T1) et la base dudit transistor.

6. Circuit selon la revendication 3, caractérisé en ce que ledit premier point du circuit (P1) est connecté à une première électrode (35) d'une jonction semiconductrice annexe (J4), jonction dont la seconde électrode (36) est connectée à la référence commune (M), une source annexe de courant (S2) étant, par ailleurs, branchée entre la première électrode (35) de la jonction semiconductrice annexe (J4) et ladite autre borne ($V_{EE}$) de la seconde alimentation, qui soumet la jonction semiconductrice annexe à un courant (I2) en sens direct, et en ce que ledit branchement série (23) comporte deux jonctions semiconductrices supplémentaires (J2), (J3).

7. Circuit selon la revendication 6, caractérisé en ce que le collecteur (28) du transistor émetteur suiveur (T1) est connecté à la référence commune (M).

8. Circuit selon l'une des revendications 1 à 7, caractérisé en ce qu'une source additionnelle de courant (S3), notamment une résistance de base additionnelle (R3), est branchée entre la base du transistor émetteur suiveur (T1) et ladite autre borne ($V_{EE}$) de la seconde alimentation.

9. Circuit selon l'une quelconque des revendications 3 à 8, caractérisé en ce que l'élément de charge (R) est une résistance.

10. Circuit selon la revendication 2 en combinaison avec l'une des revendications 6 à 9, dans lequel l'élément de charge est constitué par un transistor de même polarité que le transistor émetteur suiveur, dit transistor de charge (TZ), ledit transistor de charge ayant son émetteur suiveur, dit transistor de charge (TZ) ledit transistor de charge ayant son émetteur constituant ladite première connexion et sa base constituant ladite deuxième connexion, circuit dans lequel la borne de transit (22) peut recevoir en outre, pour un transfert vers la première logique, des signaux provenant d'un circuit de sortie (200) de la seconde logique comportant une première paire de transistors (T201, T202) à émetteurs couplés montés en porte "OU" pour la commande d'un premier transistor (T203) d'une seconde paire de transistors (T203, 204) à émetteurs couplés, caractérisé en ce que l'une des bases de la première paire de transistors (T201) constitue une première entrée de sélection de mode de conversion, l'autre base de la même paire recevant les signaux de la seconde logique, en ce que, dans la liaison du collecteur du premier transistor (T203) de la seconde paire vers la référence commune (M), est insérée une jonction semiconductrice qui constitue ladite jonction semiconductrice annexe (J4) tandis qu'une source de courant alimentant la seconde paire constitue ladite source annexe de courant (S2), en ce que le collecteur du second transistor (T204) de la seconde paire est relié à la référence commune (M) via une jonction semiconductrice (J5) en direct et, d'autre part, est connecté à la borne de transit (22), et en ce que la base du transistor de charge (TZ) constitue une seconde entrée de sélection de mode, commandée complémentairement par rapport à la première entrée de sélection.

### Patentansprüche

1. Schaltung (10) zur Signalpegelumsetzung zwischen einerseits einer ersten gesättigten Logik (11) mit zwei Ausgangssignalpegeln und mit einer Speisung von einer ersten Dauerspeisequelle (14), deren eine Klemme (15) den gemeinsamen Bezugspotentialpunkt (M) darstellt, und andererseits einer zweiten nicht gesättigten Logik (12) mit zwei anderen Signalpegeln und mit einer Speisung von einer zweiten Dauerspeisequelle (20), deren eine Klemme mit dem gemeinsamen Bezugspotentialpunkt (M) verbunden ist, und die andere Klemme (21) eine Spannung führt, deren Polarität der der anderen Klemme der ersten Dauerspeisequelle entgegengesetzt ist, wobei eine Durchgangsklemme (22) die Ausgangssignale der ersten Logik (11) zum Umsetzen dieser Ausgangssignale in Signale mit geeigneten Pegeln zum Eingeben in die zweite Logik empfängt, wobei diese Umsetzerschaltung einen Emitterfolgertransistor (T1) enthält, dessen Basis an einen ersten Schaltungspunkt (P1) auf einem bestimmten Potential in bezug auf das des gemeinsamen Bezugspunkts (M) über einen ersten pn-Übergang (J1) in Durchlassrichtung verbunden ist und weiter die Ausgangssignale der ersten Logik aus der Durchgangsklemme (22) empfängt, deren Emitter einerseits durch eine Konstantstromquelle (S1) beeinflusst wird, die ausserdem mit der genannten anderen Klemme ($V_{EE}$) der zweiten Speisequelle (20) verbunden ist, und andererseits an eine erste Verbindung (24) eines Ladeelements (Z) für die Konstantstromquelle (S1) angeschlossen ist, während die zweite Verbindung (25) dieses Elements (Z) mit einem ersten Punkt der Schaltung (P1) mit bestimmten Potential verbunden ist, dadurch gekennzeichnet, dass dieser erste Punkt (P1) der Schaltung ein auf einem bestimmten Wert fixiertes Potential gleich dem das gemeinsamen Bezugspunkts (M) oder ein Potential mit einem Wert zwischen diesem Wert und dem der anderen Klemme (21) der zweiten Dauerspeisequelle (20) führt, dass zwischen der Basis des Emitterfolgertransistors (T1) und der Durchgangsklemme (22) in Serie zumindest ein Strombegrenzungselement (R1) vorgesehen ist, und dass der Emitter des Emitterfolgertransistors (T1) mit der Konstantstromquelle (S1) direkt verbunden ist, wobei dieser Knotenpunkt, der der genannten ersten Verbindung (24) des Aufladeelements gemeinsame ist, eine Umsetzerausgangsklemme bildet, die auf geeignete Weise die Signale auf einen Eingang der zweiten Logik überträgt, wobei der Pegel dieser Signale durch das Potential des genannten ersten Schaltungspunkts (P1) durch den Spannungsabfall in dem vom Strom (I) der Konstantstromquelle (S1) durchflossenen Aufladungselement (Z) bestimmt ist, wobei der Emitterfolgertransistor (T1) blockiert wird, während der andere Pegel durch das Potential des Emitters des Emitterfolgertransistors (T1) bestimmt wird, der sich dabei im leitenden Zustand befindet.

2. Schaltung (100) zur Signalpegelumsetzung zwischen einerseits einer ersten gesättigten Logik (11) mit zwei Signalpegelausgängen und mit einer Speisung von einer ersten Dauerspeisequelle (14), deren eine Klemme (15) den gemeinsamen Bezugspotentialpunkt (M) bildet, und andererseits einer zweiten nicht gesättigten Logik (120), (200) mit zwei anderen Signalpegeln und mit einer Speisung von einer zweiten Dauerspeisequelle (20), deren eine Klemme mit dem gemeinsamen Bezugspotentialpunkt (M) verbunden ist, und die andere Klemme (21) eine Spannung führt, deren Polarität dem der anderen Klemme der ersten Dauerspeisequelle entgegengesetzt ist, wobei eine Durchgangsklemme (22) die Ausgangssignale der ersten Logik (11) zum Umsetzen dieser Ausgangssignale in Signale mit geeigneten Pegeln zum Eingeben in die zweite Logik empfängt, wobei die Umsetzerschaltung einen Emitterfolgertransistor (T1) enthält, dessen Basis mit einem ersten Punkt (P1) verbunden ist, dessen Potential in bezug auf dem des gemeinsamen Bezugspunktes (M) über einen ersten pn-Übergang (J1) in Durchgangsrichtung verbunden ist und andererseits die Ausgangssignale der ersten Logik aus der Durchgangsklemme (22) empfängt, deren Emitter einerseits durch eine Konstantstromquelle (S1) beeinflusst wird, die ausserdem mit der genannten anderen Klemme ($V_{EE}$) der zweiten Speisequelle (20) verbunden ist, und andererseits mit einer ersten Verbindung (24) eines Aufladeelements (TZ) für die Konstantstromquelle (S1) verbunden ist, dadurch gekennzeichnet, dass die zweite Verbindung dieses Aufladeelements (TZ) mit einem zweiten Schaltungspunkt (P2) verbunden ist, dessen Potential in bezug auf das des gemeinsamen Bezugspunktes (M) bestimmt ist, und dass diese ersten und zweiten Schaltungspunkte (P1) und (P2) ein auf einem Wert festgesetztes Potential gleich dem des gemeinsamen Bezugspunktes (M) oder ein Potential mit einem Wert zwischen diesem Wert und dem der anderen Klemme (21) der zweiten Dauerspeisequelle (20) führen, dass zwischen der Basis des Emitterfolgertransistors (T1) und der Durchgangsklemme (22) zumindest ein Strombegrenzungselement (R1) angeordnet ist, und dass der Emitter des Emitterfolgertransistors (T1) mit der Konstantstromquelle (S1) direkt verbunden ist, wobei dieser Knotenpunkt, der der genannten ersten Verbindung (24) des Aufladeelements gemeinsam ist, eine Umsetzerausgangsklemme bildet, die die für einen Eingang der zweiten Logik geeignete Signale führt, wobei der Pegel dieser Signale ausgehend vom Potential des genannten zweiten Schaltungspunkts (P2) durch den Spannungsabfall in dem vom Strom (I) der Konstantstromquelle (S1) durchflossenen Aufladeelement (TZ) bestimmt ist, wobei der Emitterfolgertransistor (T1) blockiert wird, während der andere Pegel durch das Potential des Emitters des Emitterfolgertransistors (T1) bestimmt wird, und dieser Transistor sich dabei im leitenden Zustand befindet.

3. Schaltung nach einem der Ansprüche 1 oder 2, dadurch gekennzeichnet, dass die Basis des Emitterfolgertransistors (T1) mit der Durchgangsklemme (22) über eine Serienanzapfung (23) verbunden ist, die einen Strombegrenzungswiderstand (R1) und mindestens einen zusätzlichen pn-Übergang (J2) in Durchlassrichtung enthält.

4. Schaltung nach Anspruch 3, dadurch gekennzeichnet, dass der Kollektor (28) des Emitterfolgertransistors (T1) mit einem der Knotenpunkte der genannten Serienanzapfung (23) verbunden ist.

5. Schaltung nach Anspruch 4, dadurch gekennzeichnet, dass ein weiterer Begrenzungswiderstand (R2) in die Serienanzapfung (23) zwischen dem Knotenpunkt angeordnet ist, an den der Kollektor (28) des Emitterfolgers (T1) und die Basis dieses Transistors angeschlossen sind.

6. Schaltung nach Anspruch 3, dadurch gekennzeichnet, dass der ersten Schaltungspunkt (P1) mit einer ersten Elektrode (35) eines benachbarten pn-Übergangs (J4) verbunden ist, dessen zweite Elektrode (36) mit dem gemeinsamen Potentialpunkt (M) verbunden ist, wobei eine benachbarte Stromquelle (S2) ausserdem zwischen der ersten Elektrode (35) des benachbarten pn-Übergangs (J4) und der genannten anderen Klemme ($V_{EE}$) der zweiten Speisequelle geschaltet ist, die den benachbarten pn-Übergang mit einem Strom (I2) in Durchgangsrichtung beliefert, und dass diese Serienanzapfung (23) zwei zusätzliche pn-Übergänge (J2) und (J3) enthält.

7. Schaltung nach Anspruch 6, dadurch gekennzeichnet, dass der Kollektor (28) des Emitterfolgertransistors (T1) mit dem gemeinsamen Bezugspotentialpunkt (M) verbunden ist.

8. Schaltung nach einem der Ansprüche 1 bis 7, dadurch gekennzeichnet, dass eine zusätzliche Stromquelle (S3), insbesondere ein zusätzlicher Basiswiderstand (R3), zwischen der Basis des Emitterfolgertransistors (T1) und der genannten anderen Klemme ($V_{EE}$) der zweiten Speisequelle geschaltet ist.

9. Schaltung nach einem oder merhreren der Ansprüche 3 bis 8, dadurch gekennzeichnet, dass der Aufladeelement (R) ein Widerstand ist.

# 0 109 106

10. Schaltung nach Anspruch 2, in der Verbindung mit einem der Ansprüche 6 bis 9, in der das Aufladeelement aus einem Transistor mit der selben Polarität besteht wie die des Emitterfolgertransistors, und mit der Bezeichnung Aufladetransistor (TZ), wobei dieser Aufladetransistor mit seinem Emitter die erste Verbindung und mit seiner Basis die zweite Verbindung darstellt, und in dieser Schaltung die Durchgangsklemme (22) ausserdem für eine Übertragung auf die erste Logik Signale aus einer Ausgangsschaltung (200) der zweiten Logik empfangen kann, die ein erstes Transistorpaar (T201, T202) enthält, deren gekoppelte Emitter ein ODER-Gatter für die Steuerung eines ersten Transistors (T203) eines zweiten Transistorpaares (T203, T204) mit gekoppelten Emittern bilden, dadurch gekennzeichnet, dass eine der Basen des ersten Transistorpaares (T201) einen ersten Auswahleingang für den Umsetzerbetrieb darstellt, und die andere Basis des gleichen Paares die Signale der zweiten Logik empfängt, dass in die Verbindung des Kollektors des ersten Transistors (T203) des zweiten Paares zum gemeinsamen Bezugspotentialpunkt (M) ein pn-Übergang eingeschaltet ist, der den genannten benachbarten pn-Übergang (J4) bildet, während eine Stromquelle zum Speisen des zweiten Paares die benachbarte Stromquelle (S2) bildet, dass der Kollektor des zweiten Transistors (T204) des zweiten Paares mit dem gemeinsamen Bezugspotentialpunkt (M) über einen pn-Übergang·(J5) in Durchgangsrichtung und zum andern mit der Durchgangsklemme (22) verbunden ist, und dass die Basis des Aufladetransistors (TZ) einen zweiten Betriebsauswahleingang bildet, der in bezug auf den ersten Auswahleingang ergänzend gesteuert wird.

**Claims**

1. A circuit (10) for translating signal levels between on the one hand a first logic (11) of the saturated type, having two output signal levels and being fed by a first d.c. supply source (14), one terminal (15) of which constitutes the common reference potential (M), and on the other hand a second logic (12) of the non-saturated type, having two other signal levels and being fed by a second d.c. supply source (20), one terminal of which is connected to the common reference potential (M) whilst its other terminal (21) is connected to a voltage having a polarity opposing that of the other terminal of the first d.c. supply source, a transit terminal (22) receiving the output signals of the first logic (11) for translation into signals having the levels suitable for the input of the second logic, said translator circuit comprising an emitter follower transistor (T1) whose base is connected to a first point (P1) of the circuit at a given potential with respect to that of the common reference (M) *via* a first forward semiconductor junction (J1) and which receives on the other hand the output signals of the first logic from the transit terminal (22), its emitter being subject on the one hand to a constant current source (S1) which, however, is connected to said other terminal (V_{EE}) of the second supply source (20), and being connected on the other hand to a first connection (24) of a load element (Z) for the constant current source (S1), whilst the second connection (25) of said element (Z) is connected to the first point (P1) of given potential of the circuit, characterized in that said first point (P1) of the circuit has a potential which is fixed at a value equal to that of the common reference (M) or to a value situated between that value and that of the other terminal (21) of the second d.c. supply source (20), between the base of the emitter follower transistor (T1) and the transit terminal (22) there being connected in series at least one current limiting element (R1), the emitter of the emitter follower transistor (T1) being connected directly to the constant current source (S1), this node which is common to said first connection (24) of the load element constituting an output terminal of the translator which carries the suitable signals to an input of the second logic, or level of said signals being determined, on the basis of the potential of said first point (P1) of the circuit, by the voltage drop in the load element (Z) which is traversed by the current (I) of the constant current source (S1), the emitter follower transistor (T1) being cut off, whilst the other level is determined by the potential of the emitter of the emitter follower transistor (T1) which is then conductive.

2. A circuit (100) for translating signal levels between on the one hand a first logic (11) of the saturated type, having two output signal levels and being fed by a first d.c. supply source (14), one terminal (15) of which constitutes the common reference potential (M) and on the other hand a second logic (120) (200) of the non-saturated type, having two other signal levels and being fed by a second d.c. supply source (20), one terminal of which is connected to the common reference potential (M) whilst its other terminal (21) is connected to a voltage having a polarity opposing that of the other terminal of the first d.c. supply source, a transit terminal (22) receiving the output signals of the first logic (11) for translation into signals having the levels suitable for the input of the second logic, said translator circuit comprising an emitter follower transistor (T1) whose base is connected to a first point (P1) having a given potential with respect to that of the common reference (M) *via* a first forward semiconductor junction (J1) and which receives on the other hand the output signals of the first logic from the transit terminal (22), its emitter being subject on the one hand to a constant current source (S1) which, however, is connected to said other terminal (V_{EE}) of the second supply source (20), and being connected on the other hand to a first connection (24) of a load element (TZ) for the constant current source (S1), characterized in that the second connection of said element (TZ) is connected to a second circuit point (P2) of given potential with respect to that of the common reference (M), said first (P1) and second (P2) points of the circuit having a potential which is fixed at a value equal to that of the common reference (M) or to a value situated between that value and that of said other terminal (21) of the second d.c. supply source (20), between the base of the emitter follower transistor (T1) and the transit terminal (22) there being connected in series at least one current limiting element (R1), the emitter of the emitter follower transistor (T1) being connected directly to the constant current source (S1), this node which is common to said first connection (24) of the load element constituting an output terminal of the translator which carries the suitable signals to an input of the second logic, one level of said signals being determined, on the basis of the potential of said second point (P2) of the circuit, by the voltage drop in the load element (TZ) which is traversed by the current (I) of the constant current source (S1), the emitter follower transistor (T1) being cut off, whilst the other level is determined by the potential of the emitter of the emitter follower transistor (T1) which is then conductive.

3. A circuit as claimed in any one of the Claims 1 or 2, characterized in that the base of the emitter follower transistor (T1) is connected to the transit terminal (22) *via* a series arrangement (23) which includes a current limiting resistor (R1) and at least one supplementary forward semiconductor junction (J2).

4. A circuit as claimed in Claim 3, characterized in that the collector (28) of the emitter follower transistor (T1) is connected to one of the nodes of said series arrangement (23).

5. A circuit as claimed in Claim 4, characterized in that an additional limiting resistor (R2) is inserted in said series arrangement (23) between the node whereto the collector (28) of the emitter follower transistor (T1) is connected and the base of said transistor.

6. A circuit as claimed in Claim 3, characterized in that said first point (P1) of the circuit is connected to a first electrode (35) of an associated semiconductor junction (J4) whose second electrode (36) is connected to the common reference (M), an associated current source (S2) being connected, however, between the first electrode (35) of the associated semiconductor junction (J4) and said other terminal ($V_{EE}$) of the second supply source, thus subjecting the associated semiconductor junction to a forward current (I2), and in that said series arrangement (23) comprises two supplementary semiconductor junctions (J2, J3).

7. A circuit as claimed in Claim 6, characterized in that the collector (28) of the emitter follower transistor (T1) is connected to the common reference (M).

8. A circuit as claimed in any one of Claims 1 to 7, characterized in that an additional current source (S3), notably an additional base resistor (R3), is connected between the base of the emitter follower transistor (T1) and said other terminal ($V_{EE}$) of the second supply source.

9. A circuit as claimed in any one of Claims 3 to 8, characterized in that the load element (R) is a resistor.

10. A circuit as claimed in Claims 2 in combination with one of the Claims 6 to 9, in which the load element is constituted by a transistor having the same polarity as the emitter follower transistor and designated as load transistor ($T_z$) whose emitter constitutes said first connection and whose base constitutes said second connection, transit terminal (22) can, moreover, receive for transfer to the first logic signals originating from an output circuit (200) of the second logic, comprising a first pair of emitter-coupled transistors (T201, T202) connected as an "OR" gate for the control of a first transistor (T203) of a second pair of emitter-coupled transistors (T203, T204), characterized in that one of the bases of the first pair of transistors (T201) constitutes a first translation mode selection input, the other base of the same pair receiving the signals of the second logic, in that the connection between the collector of the first transistor (T203) of the second pair and the common reference (M) includes a semiconductor junction which constitutes said associated semiconductor junction (J4), whilst a current source feeding the second pair constitutes said associated current source (S2), in that the collector of the second transistor (T204) of the second pair is connected to the common reference (M) *via* a forward semiconductor junction (J5) and is connected on the other hand to the transit terminal (22), and in that the base of the load transistor (TZ) constitutes a second mode selection input controlled complementarily with respect to the first selection input.

FIG.1

0 109 106

FIG.2

FIG.3

2

FIG.4

FIG.5

0 109 106